# EUROPEAN PATENT APPLICATION

(11) **EP 3 236 547 A1**
(43) Date of publication of application: **25.10.2017**
(21) Application number: 16305467.9
(22) Date of filing: 21.04.2016
(51) Int. Cl.: H01S 3/16, H01S 3/094, H01S 3/213

(54) **RANDOM LASING PHOTO-CURABLE COMPOSITION FOR USE AS RANDOM LASING GAIN MEDIUM**

(71) Applicant: Université de Strasbourg, 67000 Strasbourg (FR); CENTRE NATIONAL DE LA RECHERCHE SCIENTIFIQUE -CNRS-, 75016 Paris (FR); Karlsruher Institut für Technologie Institute of Inorganic Chemistry, 76131 Karlsruhe (DE)
(72) Inventor: DE COLA, Luisa, 67000 Strasbourg (FR); GENOVESE, Damiano, Bologna 40137 (IT); BARNA, Valentin, Bucharest (RO)
(74) Representative: Cabinet Plasseraud

(57) **Abstract**

The present invention relates to a random lasing photo-curable composition (1) for use as random lasing gain medium comprising:
- laser dye molecules (11);
- an optical glue (12) for the laser dye molecules to be suspended therein;
wherein the optical glue is mercapto ester-based and comprises methacrylate and/or derivatives thereof.

The present invention also relates to a random lasing system with a gain medium made of at least partially of random lasing photo-curable composition, and methods for manufacturing such random lasing system.

## Description

### Field of the invention

The present invention relates to the field of random laser and especially to random lasing photo-curable composition for use as a gain medium in a random laser and to methods for manufacturing a random laser using such composition.

### Prior art

Lasers are ubiquitous in everyday life. Properties such as monochromaticity, directionality and high intensity have determined their use as light sources in applications ranging from daily use appliances to the most currently sophisticated technologies.

The search for miniaturised systems which can also be soft, flexible, and moulded in different shapes matching any individual application, is a challenging run for many academic and industrial researchers.

One even more demanding task is the substitution of delicate and expensive resonating systems (macro and micro cavities, photonic crystals and photonic structures etc.), typical of traditional lasers, with new devices that are able to grant an efficient laser action without suffering from drawbacks such as high price and fragility.

Random lasers have been developed and have attracted the interest of many researchers for the last twenty years. In such laser, the lasing process does not rely on any resonating system at all. On the contrary, it uses a disordered gain medium which enhances light scattering and diffusion. It has been demonstrated that random lasing may occur upon optical pumping of a gain medium containing nanoparticles (*i.e.* inorganic nanoparticles such as TiO2, ZnO, Ag, or polymeric nanoparticles such as polymethacrylates) or of a medium with intrinsically disordered heterogeneous microstructure (*i.e.* silica xerogel matrix, liquid crystals). Light is diffused around the gain medium in much the same way as it is on white paint and in clouds, and photons emitted spontaneously by the gain medium in turn stimulate other radiative transitions, unleashing yet more photons and hence producing random laser emission.

A major advantage of random lasers over regular lasers is that their production is cheap and the obtained lasing technology relatively simple.

One example of such random lasers is discussed in Lin and Hsiao, in Optical Materials Express, 2014. The authors of this scientific paper reported to produce a lasing system by:
- mixing a liquid crystal (nematic LC) with a dye obtaining a dye-doped liquid crytal (DD-LC) mixture;
- adding monomer NOA65 (Norland Optical Adhesive 65) into the DD-LC mixture (NOA65-doped DD-LC mixture);
- filling capillary tubes (inner diameter of 110 µm) with the NOA65-doped DD-LC mixture; and
- curing NOA64 in the tubes.

The authors found out that addition of 10 wt.% to 20 wt.% of NOA into the DD-LC mixture lowers the threshold of pump energy and increases the number of emission spikes. They believe that this is due to the increase of polymer clusters so that light scattering in the NOA64 doped DD-LC was increased.

The authors also observed that for NOA65-doped DD-LC at a higher amount (above 20 wt.% NOA65), the amplitude of the emission spikes diminished. This is believed to be due to the scattering loss being increased in the NOA65-doped DD-LC mixture. Thus these researchers have strongly advised against using more than 20 wt.% NOA65.

Thus, despite the fact that no formation of resonating system is required, the solution disclosed in this article necessitates the manufacturing of DD-LC which is quite burdensome, and the manufacturing of a heterogeneous mixture (NOA65-doped DD-LC mixture) which may present a limited colloidal stability in time. Indeed, according to the authors, the DD-LC material and the heterogeneous mixture with NOA65 are essential to obtain a disordered materials and recurrent multiple light scattering therewithin. The large amount of scattering of this heterogeneous mixture, moreover, resulted in light emission in all directions, which certainly limits the possible applications of the system disclosed in this article.

### Summary of the invention

Therefore, one objective of the present invention is to provide a more affordable and more easily producible lasing system that is able to yield an easy-to-use laser radiation (i.e., emission in a specific direction).

To this aim, the present invention provides a random lasing photo-curable composition for use as gain medium comprising:
- laser dye molecules;
- an optical glue for the laser dye molecules to be solvated therein;
wherein the optical glue is mercapto ester-based and comprises methacrylate and/or derivatives thereof.

The random lasing photo-curable composition of the invention provides a less complex manufacturing process in comparison with the prior art. Indeed, the fact that only one component is required, that is intrinsically disordered and that efficiently solvates the dye, and the fact that the random lasing photo-curable composition is a soft material which may be cured under light, makes it possible to obtain any shape at a resolution of that of photolithography, *i.e.* few micrometres, which still exhibits lasing properties. Also, since it random lases, no resonating structure is needed: the gain medium obtained from the random lasing photo-curable composition is resonatorless / mirrorless. The random lasing composition lases with preferential directions that is dependent on the geometry of the lasing system, which can be in either solid or liquid state. The fact that the gain matrix is made of an optical glue and laser dye(s) makes it an affordable technology. The use of optical glue has also another advantage: it is compatible with a wide range of laser dyes.

Thus, it enables greater variety of types of manufacturing processes and uses. Random lasing phenomenon has been demonstrated for standard wedge cells (*i.e.* a cell where two windows are not perfectly parallel), freely suspended objects such as thin films and droplets, and also in microstructures obtained with photolithography. It has been proven to occur before and even after the random lasing photo-curable composition is photo-cured. Also, random lasing features as small as 10 µm or even less could be obtained.

Other non-limiting features of the random lasing photo-curable composition are as follows.

Additionally the optical glue may comprise at most 85 wt.% mercapto ester. Alternatively or additionally, the optical glue may comprise at least 15 wt.% methacrylate or derivatives thereof. Alternatively or additionally still, the methacrylate or derivatives thereof may be selected from the group consisting of: tetrahydrofurfuryl methacylate.

In another aspect of the invention, it is also provided a random lasing system with a gain medium made from the random lasing photo-curable composition.

Other non-limiting features of the random lasing system are as follows.

Additionally, the random lasing photo-curable composition in the gain medium may be in a liquid form. Alternatively, the random lasing photo-curable composition in the gain medium may be in a solid form. In both cases, the lasing photo-curable composition in the gain medium may be a self-standing block or film, or suspended objects.

In still another aspect of the invention, a method for manufacturing a gain medium in a solid form for a random lasing system is provided. The method comprises:
- mixing laser dye with an optical glue to obtain a photo-curable mixture;
- coating a substrate with the photo-curable mixture;
- masking the substrate with a pattern-baring mask;
- irradiating the substrate through the mask;
- removing the mask;
- washing uncured photo-curable mixture;
wherein the optical glue is mercapto ester-based and comprises methacrylate and/or derivatives thereof.

Alternatively, a method for manufacturing a gain medium in a liquid form enclosed in a cell for a random lasing is provided. The method comprises:
- mixing laser dye with an optical glue to obtain a photo-curable mixture;
- filling the cell with the photo-curable mixture;
- closing the cell;
wherein the optical glue is mercapto ester-based and comprises methacrylate and/or derivatives thereof.

More generally, the present invention provides a use of an optical glue as a solvating medium for a laser dye forming a gain medium in a random lasing system, wherein the optical glue is mercapto ester-based and comprises methacrylate and/or derivatives thereof.

Other non-limiting features are as follows.

The optical glue may comprise at most 85 wt.% mercapto ester. Additionally or alternatively, the optical glue may comprise at least 15 wt.% methacrylate or derivatives thereof. Additionally or alternatively still, the methacrylate or derivatives thereof may be selected from the group consisting of: tetrahydrofurfuryl methacylate.

Thus, the present invention has great potential for applications, particularly in any field that requires intense, directional and spectrally narrow emission as well as compatibility with micrometric optical circuits. These fields range from communication and photonics to (bio)sensing and imaging.

### Brief description of the drawings

Additional objects and advantages of the invention will become apparent to those skilled in the art upon reference to the detailed description taken in conjunction with the provided figures. The detailed description and the provided figures are intended for an illustrative purpose only and are in no way limiting.
Fig. 1 is a schematic illustration of a random lasing photo-curable mixture according to the invention;
Fig. 2 is a schematic illustration of a self-standing solid (photocured) form of a random lasing system according to one example of the invention;
Fig. 3 is a schematic illustration of a random lasing system according to one example of the invention with suspended liquid or solid droplets of random lasing photo-curable composition;
Fig. 4 is a schematic illustration of a random lasing system according to one example of the invention with liquid or solid wedge cell of random lasing photo-curable composition;
Fig. 5 is a flowchart illustrating the steps of a method for manufacturing a random lasing system with optical glue in a solid form;
Fig. 6 is a flowchart illustrating the steps of a method for manufacturing a random lasing system with optical glue in a liquid form;
Fig. 7 is a photograph showing free standing objects presenting random lasing properties and made with the random lasing photo-curable composition of the present invention, especially a) is a triangular object, b) is a circular object and c) is a squared object;
Fig. 8 is a photograph showing a free standing object with random lasing properties (bright part of the photograph) with more complex shape, especially lettering, and which is made with the random lasing photo-curable composition of the present invention ;
Fig. 9 is a photograph showing the random lasing properties 3 of a droplet 21 of the random lasing photo-curable composition of the present invention;
Fig. 10 is a photograph showing the random lasing properties 3 of the random lasing photo-curable composition of the present invention within a wedge cell 22;
Fig. 11 is a graph showing the characteristic spectra of fluorescence emission and of random laser emission of a gain medium in a solid form at two different pumping energies, according to one example of the invention (microstructures photo-cured by photolithography);
Fig. 12 is a graph showing the dependency of the output (emission) intensity on the input (optical pump) intensity for a solid microstructure, according to one example of the invention, the graph shows the occurrence of random laser action upon optical pumping exceeding the energy threshold as indicated in the figure.

### Definition

The term "derivative" is used here as meaning any molecules comprising the core structure of a given molecule, *i.e.* all atoms other than hydrogen in the same spatial configuration. In other words a derivative of a given molecule presents at least one substituted hydrogen atom in comparison to the given molecule.

### Description

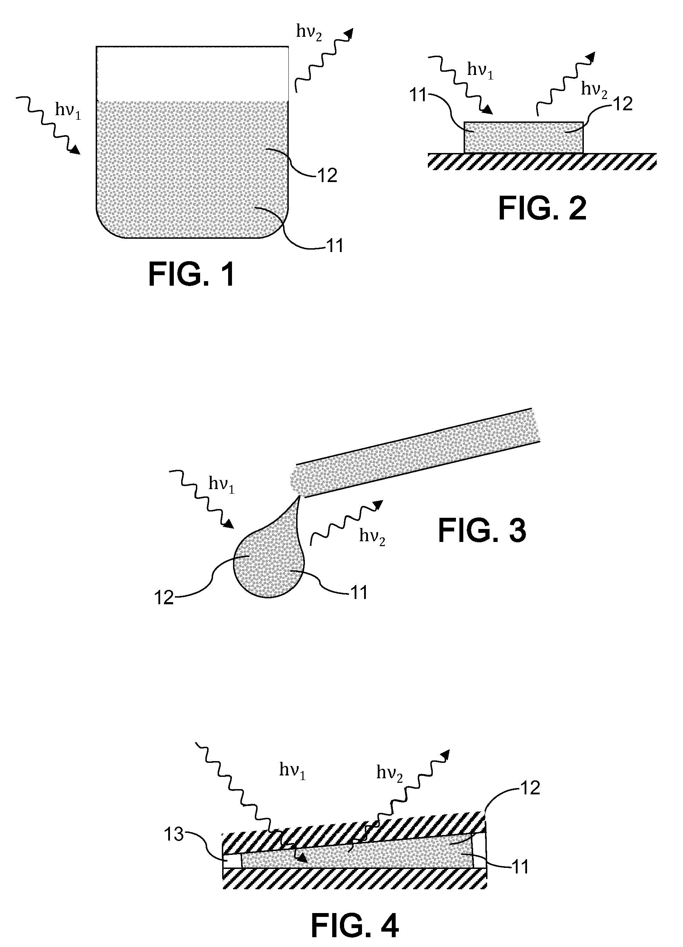

A random lasing photo-curable composition for use as a random lasing gain medium according to one aspect of the invention and a random lasing system with a gain medium made from the random lasing photo-curable composition according to another aspect of the invention will be describe hereafter with reference to figures 1 to 4.

### Composition

The random lasing photo-curable composition 1 comprises laser dye molecules 11 and an optical glue 12 for the laser dye molecules 11 to be dissolved therein.

Laser dyes 11 are usually organic molecules with molecular weights of a few hundred g/mol used in dye laser. In such laser, these dyes are usually dissolved in a suitable liquid solvent or used to dope solid-state matrices to provide gain media for solid state dye lasers. Laser dyes are typically fluorescent, *i.e.* when excited with light at a given wavelength, they produce light at another wavelength.

The laser dye may be chosen from a large variety, including the group consisting of pyrromethene, coumarin, fluorescein, rhodamine, polyphenyl, umbelliferone, 4-(dicyanomethylene)-2-methyl-6-(4-dimethylaminostyryl)-4H-pyran and their derivatives. The random lasing photo-curable composition 1 may also comprise a mixture of at least two dye molecules.

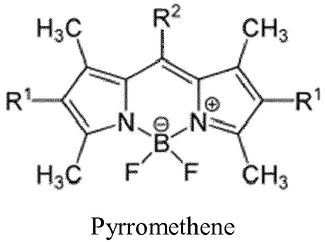

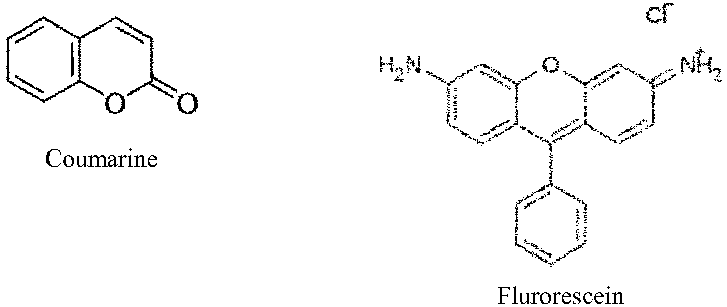

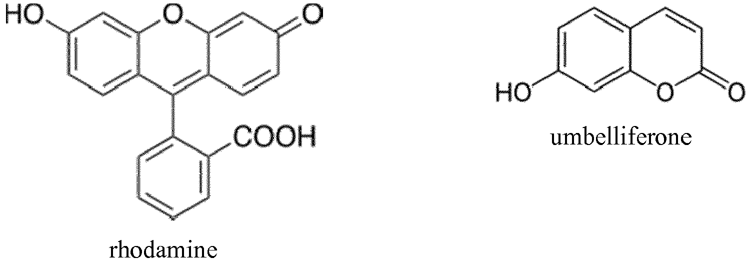

In the following, an exemplary list of laser dyes that can be used in the invention. These mentioned laser dyes have been experimentally investigated and proved to exhibit laser emission in various mixtures with an optical glue, in particular NOA and more in particular NOA 81, NOA 87 and NOA 61. To prove the generality of the concept a dye from each family of: coumarin, fluorescein, rylene, cyanine, pyrromethane, stilbene, push-pull (charge transfer) dyes have been tested.

Pyrromethene 597: 4,4-difluoro-2,6-di-t-butyl-1,3,5,7,8-pentamethyl-4-bora-3a,4a-diaza-s-indacene (a.k.a. 2,6-di-t-butyl-1,3,5,7,8-pentamethyl pyrromethenedifluoro-borate Complex) 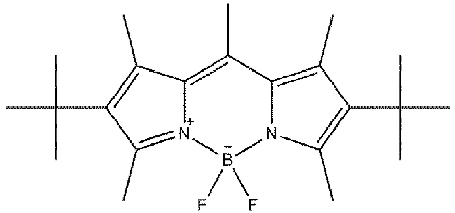 DCM: 4-dicyanmethylene-2-methyl-6-(p-dimethylaminostyryl)-4H-pyran

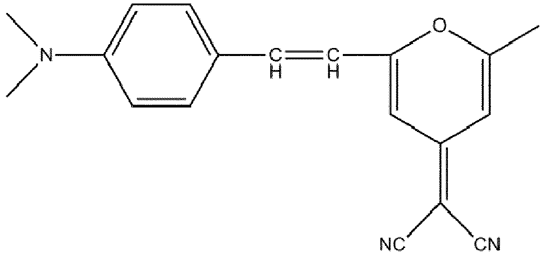

Pyrromethene 567: 4,4-difluoro-2,6-diethyl-1,3,5,7,8-pentamethyl-4-bora-3a,4a-diaza-s-indacene (a.k.a. 2,6-diethyl-1,3,5,7,8-pentamethylpyrromethenedifluoroborate Complex)

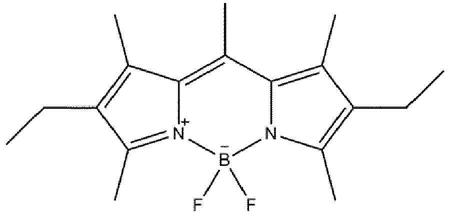

Pyrromethene 580: 4,4-Difluoro-2,6-di-n-butyl-1,3,5,7,8-pentamethyl-4-bora-3a,4a-diaza-s-indacene (a.k.a. 2,6-Di-n-butyl-1,3,5,7,8-pentamethylpyrromethenedifluoro-borate Complex)

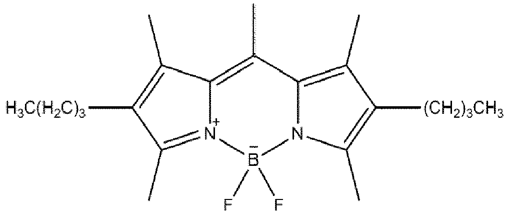

Pyrromethene 650: 4,4-Difluoro-8-cyano-1,2,3,5,6,7-hexamethyl-4-bora-3a,4a-diaza-S-indacene (a.k.a. 8-Cyano-1,2,3,5,6,7-hexamethylpyrromethenedifluoroborate Complex)

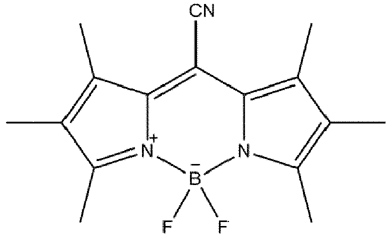

Rhodamine 6G or Rhodamine 590: benzoic acid, 2-[6-(ethylamino)-3-(ethylimino)-2,7-dimethyl-3H-xanthen-9-yl]-ethyl ester, monohydrochloride

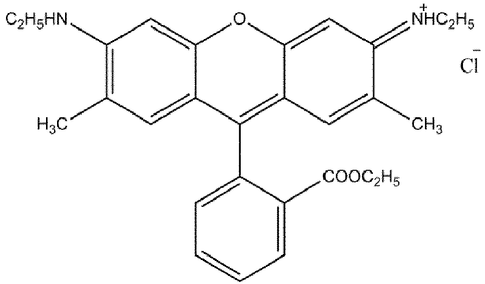

Pyridine 2 or LDS 722: 1-ethyl-4-(4-(p-dimethylaminophenyl)-1,3-butadienyl)-pyridinium perchlorate

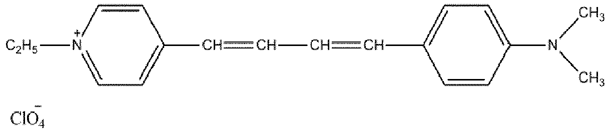

Coumarin 153 or Coumarin 540A: 2,3,5,6-1H,4H-tetrahydro-8-trifluormethylquino-lizino-[9,9a,1-gh]coumarin

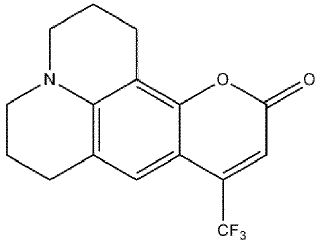

Pyridine 1 or LDS 698: 1-ethyl-2-(4-(p-dimethylaminophenyl)-1,3-butadienyl)-pyridinium perchlorate

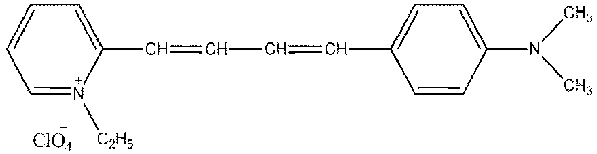

Coumarin 47 or Coumarin 460: 7-diethylamino-4-methylcoumarin

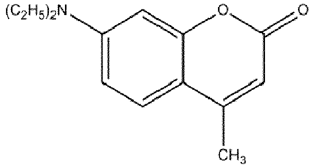

Coumarin 120 or Coumarin 440: 7-amino-4-methylcoumarin

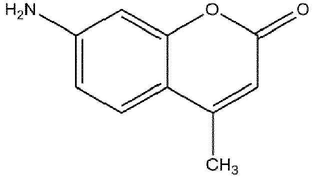

Coumarin 102 or Coumarin 480: 2,3,5,6-1H,4H-Tetrahydro-8-methylquinolizino-[9,9a,1-gh]-coumarin

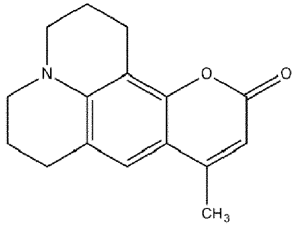

Coumarin 2 or Coumarin 450: 7-amino-4-methylcoumarin

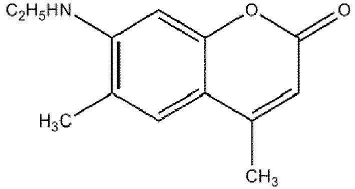

Rhodamine 19 or Rhodamine 575: benzoic acid, 2-[6-(ethylamino)-3-(ethylimino)-2,7-dimethyl-3H-xanthen-9-yl], perchlorate

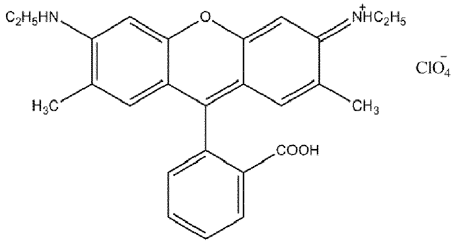

Rhodamine B or Rhodamine 610: 2-[6-(Diethylamino)-3-(diethylimino)-3H-xanthen-9-yl] benzoic acid

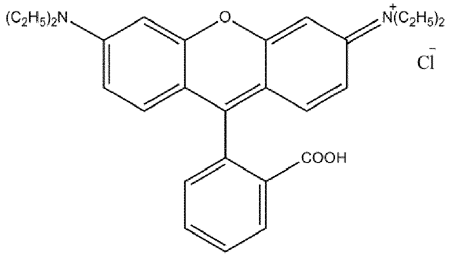

Coumarin 307 or Coumarin 503: 7-ethylamino-6-methyl-4-trifluormethylcoumarin

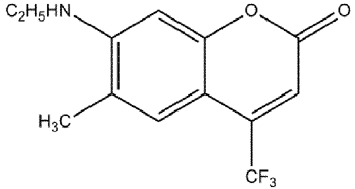

Coumarin 500: 7-ethylamino-4-trifluormethylcoumarin

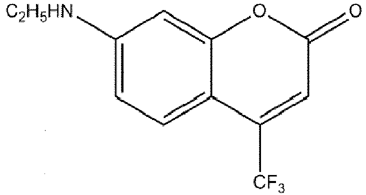

Coumarin 466: 7-diethylaminocoumarin

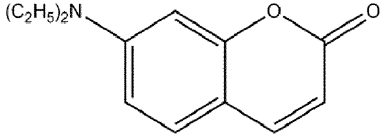

Stilbene 3 or Stilbene 420: 2,2'-([1,1'-biphenyl]-4,4'-diyldi-2,1-ethenediyl)-bis-benzenesulfonic acid disodium salt

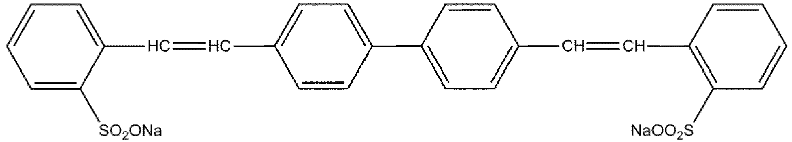

DXP: N,N'-Bis(2,6-dimethylphenyl)perylene-3,4,9,10-tetracarboxylic diimide

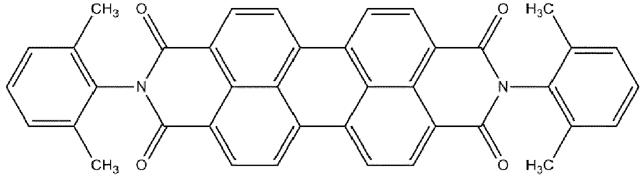

Based on the required application range in terms of wavelength of lasing emission these dyes (and derivatives) can be employed as laser dyes for the invention, while mostly covering any spectral position from UV, particularly UVA, to visible light upto near infrared.

The amount of laser dye in the composition is typically up to 1 % of the weight of the composition, preferably from 0.01 to 0.8 wt.%, still preferably from 0.1 to 0.5 wt.% more preferably about 0.3 wt.%. Nevertheless, by using a higher percentage of dye (up to 5 wt.% in general) will also result in obtaining lasing emission. Yet, in this latter case, aggregation and subsequent sedimentation (if liquid) of the dye molecules is highly probable and a non-uniform systems is more likely to be obtained.

Optical glue means, when in a liquid form, any substance exhibiting adhesive properties and which is optically clear, and when in a solid form, the cured or desiccated product of the substance exhibiting adhesive properties. In other words, optical glues used in the invention are substantially transparent to pumping and emitted light, *i.e.* at least 75 % transparent, preferably at least 80 %, at least 85 %, at least 90 %, at least 95 %, at least 99 %. Advantageously, the optical glue is at least 75 % transparent to visible light, preferably at least 80 %, at least 85 %, at least 90 %, at least 95 %, at least 99 %.

The optical glue is a mercapto ester-based optical glue and further comprises methacrylic acid (CH₂=C(CH₃)COOH) and/or derivatives thereof.

By "mercapto ester-based optical glue" it is meant an optical glue comprising at least 55 wt.% mercapto ester. Preferably the optical glue comprises at least 60 wt/%, at least 65 wt.%, at least 70 wt.% or at least 75 wt.%. The optical glue preferably comprises at most 85 wt.% mercapto ester, preferably at most 80 wt.% or at most 75 wt.%. "Mercapto ester" designates any molecule of the following general formula: R1-S-R2-C(O)-O-R3, wherein S comprises a thiol group (mercapto) and R1, R2 and R3 are functional groups.

The optical glue preferably comprises two different mercapto esters. In one embodiment, the optical glue comprises at least 30 wt.% of a first mercapto ester, preferably at least 35 wt.%, at least 40 wt.%, at least 45 wt.%. In such case, the optical glue preferably comprises at most 50 wt.% of the first mercapto ester. Additionally or alternatively, the optical glue comprises at least 25 wt.% of a second mercapto ester, preferably at least 30 wt.%, at least 35 wt.%, at least 40 wt.%, at least 45 wt.%, at least 50 wt.%, at least 55 wt.%. In such case, the optical glue preferably comprises at most 60 wt.% of the second mercapto ester.

The optical glue preferably comprises a methacrylic acid derivative over methacrylic acid. Advantageously, the methacrylic acid derivative is an ester, more commonly referred to as methacrylate, which has the following general formula: CH₂=C(CH₃)COOR". Preferably, R" comprises a ring, preferably the ring comprises an heteroatom, preferably the ring is formed by 3, 4, 5, 6, 7 or 8 atoms. Preferably, R" is tetrahydrofurfuryl.

The optical glue preferably comprises at least 15 wt.%, preferably at least 20 wt.%, at most 25 wt.%, methacrylic acid (CH₂=C(CH₃)COOH) and/or derivatives thereof, especially a methacrylate, more specifically one chosen in the group mentioned above.

Preferably the optical glue is UV curable, visible light curable, IR curable.

It may be important to pay attention to the viscosity of the random lasing photo-curable composition for processability. For example in some applications, viscosity should not be too high so that the random lasing photo-curable composition may be applied and/or loaded easily and smoothly. In other applications (for example coating), viscosity should not be too low.

The random lasing photo-curable composition preferably exhibits a viscosity comprised between 15 cps and 25000 cps, and preferably viscosity comprised between 100 cps and 2000 cps.

Viscosity is measured with standard viscometry methods, preferably with the falling ball method or with the U-tube method, or preferably with a rheometer.

Time required for full curing depends on two geometrical dimensions: the surface of the composition exposed to light and volume of the composition to be cured. Basically, the bigger the surface (S), the shorter the time (T); also the bigger the volume (V), the longer the time (T). Thus time required for full curing is proportional to S⁻¹ and to V (thus to V/S).

Preferably, full curing time must not be too long to be able to speed up production of random lasing system with gain medium. Thus, the random lasing photo-curable composition preferably exhibits a full curing time of 10 ms to 1 hour, preferably 100 ms to 10 min, more preferably 500 ms to 5 min, preferably still 1 s to 1 minute.

### System

The random lasing system of the invention comprises a gain medium at least partly, preferably fully, made from the random lasing photo-curable composition described above. Since the invention is about random laser, the gain medium is resonatorless/mirrorless.

The gain medium may be in a liquid form or in a solid form. It is understood in this present description that the solid form of the gain medium is obtained by curing the random lasing photo-curable composition.

When in a liquid form, the random lasing photo-curable composition makes up substantially 100 wt.% of the gain medium, which is usually enclosed in a cell, preferably a liquid-tight and/or gas-tight cell. In other words, the random lasing photo-curable composition makes up at least 80 wt.% of the gain medium, preferably at least 85 wt.%, at least 95 wt.%, at least 96 wt.%, at least 97 wt.%, at least 98 wt.%, at least 99 wt.%.

The cell may be a face parallel or a wedge cell (*i.e.* made of two plates spaced apart with differential distances at one and the other ends). The plates are typically kept together by means of metallic clips or glue.

The plates may have whatever thickness is required by the application (and the available space), whether mechanical stress resistance is required or not etc. (yet, thinner plates are preferred in order to reduce optical losses).

Preferably one plate is 50 µm to 2 mm thick, preferably 100 µm to 1.75 mm, preferably 120 µm to 1.5 mm, preferably 0.15 mm or 1 mm.

Preferably the other plate is 50 µm to 2 mm thick, preferably 100 µm to 1.75 mm, preferably 120 µm to 1.5 mm, preferably 0.15 mm or 1 mm.

Preferably the two plates are spaced apart by spacers. The spacers can be made from various materials, including glass, metal, hard polymers. The spacers should be compatible with the composition (optical glues) and with the curing process. Preferably the spacers are made of a thermoplastic polymer, preferably of the polyester family, still preferably polyethylene terephthalate and more precisely biaxially-oriented polyethylene terephthalate also known as Mylar.

The spacers may have whatever thickness is required by the application (i.e. from few microns up to as high as mm or even cm). Higher thickness can in principle yield higher intensity of laser emission.

Preferably the two plates are spaced at one end of 20 to 1000 µm, preferably 50 to 500 µm, preferably 75 to 200 µm, still preferably about 100 µm.

Preferably the two plates are spaced at the other end of 0 (no spacer) to 1000 µm, preferably 50 to 500 µm, preferably 75 to 200 µm, still preferably about 100 µm.

Spacing differently the plates at their ends makes it possible to avoid formation of a Fabry-Pérot resonator cavity. Difference in plates spacing, i.e. wedge cell geometry, can be chosen to avoid formation of a Fabry-Pérot resonator cavity at the pumping and lasing wavelengths, but this is not a necessary requirement for the lasing film to operate.

The two plates are substantially transparent at least to the pumping and lasing wavelength, *i.e.* at least 75 % transparent thereto, preferably at least 80 %, at least 85 %, at least 90 %, at least 95 %, at least 99 %. In one particular embodiment, one side of one of the plates can be close to 100% reflective (e.g. at least 75%, preferably at least 80 %, at least 85 %, at least 90 %, at least 95 %, at least 99 %) for both pumping and lasing beam in order to force all the radiation to come out from the input side. This also making the reflected part of the input beam travel twice within the gain medium can help improve the overall efficiency of the lasing system. In another particular embodiment, both sides can be close to 100% reflective at least for the lasing beam. Thus, since differential spacers are used, the resulting lasing beam can be collected at the edge of the plates after multiple internal reflections along a path between the plates (*i.e.* whispering gallery modes).

When in a solid form, the gain medium may be made of a self-standing block or film, or a plurality of suspended free-standing objects such as films or droplets or other geometric forms of different sizes (down to the resolution of photolithography, i.e. few microns), *i.e.* the objects are suspended in a liquid mixture, in gas or in a solid matrix.

A film is an object exhibiting one dimension which is substantially smaller than the other two. Preferably the two bigger dimensions are at least 100 times of the smallest one, preferably at least 200 times, preferably at least 500 times, preferably at least 1000 times or even more. The film is generally adhered to a support which can be made of any kind of material as long as there is a good adherence between the support and the film. However, in other applications, the support may not be necessary, especially when the film is sufficiently thick. Thickness of the film is at least 1 µm, preferably at least 10 µm, preferably at least 20 µm, preferably at least 50 µm, preferably at least 100 µm, preferably at least 500 µm. Thickness of the active media can reach a centimetre-size or even more if compactness of the system is not an issue, and higher emission energy values are required.

The liquid mixture is preferably made of water. The solid matrix is preferably made of PDMS.

The self-standing block may be microscopic, preferably with a height/characteristic length of 1 µm to 200 µm, and preferably of 10 µm to 100 µm The height is determined orthogonally to the surface of the element supporting the self-standing block. The characteristic length is the longest length measurable orthogonally to the height. The self-standing block may be macroscopic, preferably with a height/characteristic length of 1 mm to 5 cm, especially if it is wished to obtain higher emission intensities.

The self-standing film preferably has a thickness of at least 5 µm, still preferably at least 10 µm, at least 25 µm, at least 50 µm, at least 100 µm.

The suspended objects preferably exhibit an average equivalent diameter comprised between 5 µm and 5 cm. The equivalent diameter is the diameter of a sphere of the same volume than the object.

The random lasing system typically comprises a pumping unit for providing the gain medium with energy. The pumping unit is preferably an optical pumping unit, preferably equipped with controls for intensity, size and polarization of the optical pumping beam.

Preferably the pumping unit is an optical pumping unit such as a pulsed Nd:YAG laser coupled to a master oscillator power amplifier system. The pumping pulse duration can be for example in the nanosecond range, femtosecond range, and picosecond.

This new class of materials has important potential for application in all fields that require very intense and spectrally narrow emission, and that in addition can be coupled with micrometric optical circuits. These fields range from communication and photonics, to (bio)sensing and imaging, just to name a few.

### Methods

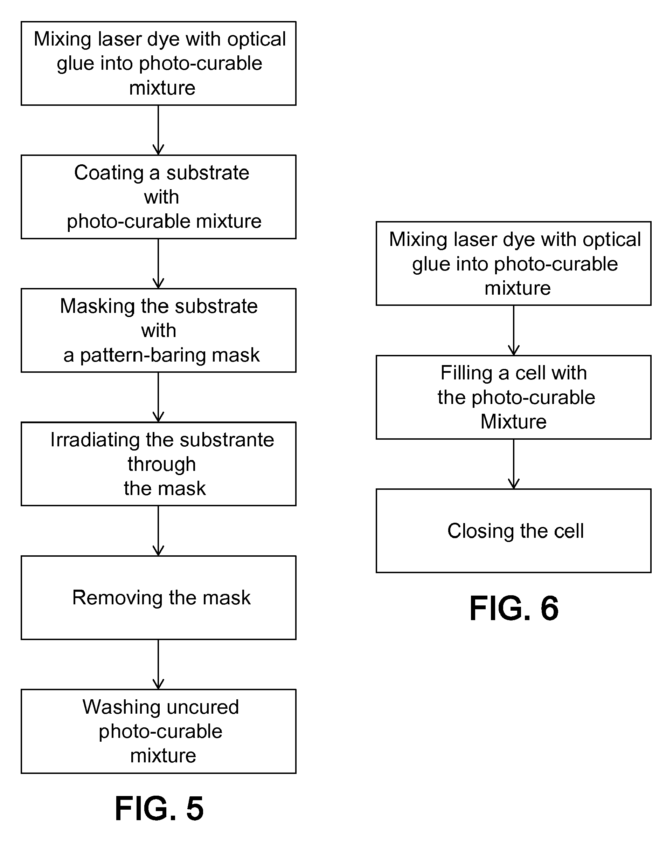

Methods for manufacturing gain medium for random lasing systems according to the invention will be described hereafter with reference to figures 5 and 6.

### Systems with solid state gain medium

One method is a method for manufacturing a gain medium in a solid form for a random lasing system (figure 5). This method comprises mixing laser dye with the optical glue as defined above to obtain a random lasing photo-curable composition, coating a substrate with the composition, masking the substrate with a pattern-baring mask, irradiating the substrate through the mask to cure at least partially the composition, removing the mask, and washing uncured composition.

Composition at unmasked areas of the pattern is cured by irradiation and composition at masked areas of the pattern is washed away. The cured composition is used as a gain medium.

Thus, this method is very simple and enables a large variety of shape for the gain medium such as films, droplets or any shape obtainable through inkjet techniques.

Coating may be obtained by spraying, spin-coating, dip-coating or roll-to-roll processing.

Irradiating may be carried out using UV light, visible light, IR light, or a combination thereof.

### Systems with liquid state gain medium

Another method is a method for manufacturing a gain medium in a liquid form contained in a cell for a random lasing system (figure 6), such as a wedge cell (or parallel face cell). The method comprises mixing laser dye with an optical glue to obtain a photo-curable mixture, filling the cell with the photo-curable mixture and closing the cell. The liquid state fain medium can also be used in free standing or freely suspended modes, such as films, droplets, or other geometrical shapes deposited on a surface or suspended by means of surface tension forces.

### Examples

A random lasing photo-curable composition was obtained by mixing laser dye PM597 of Exciton and optical glues NOA81, or NOA61, or NOA 68 of Thorlabs, which are representative of NOA, so that the laser dye makes up 0.5 wt.% of the composition.

Wedge cells were made from two 0.15 mm or 1 mm thick microscope glass plates separated by DuPont Mylar spacers with a thickness of 100 µm at one edge and 23 µm at the other one and closed at the sides by means of metallic clips or glue.

The wedge cells were either capillarily filled with the random lasing photo-curable composition after formation thereof or by depositing a droplet of the the random lasing photo-curable composition on one of the plate and then applying pressure onto the droplet through the other plate during fabrication of the wedge cells.

Thus liquid gain media have been obtained.

The gain media was optically pumped by means of a pump laser system comprising a pulsed Nd:YAG laser (frequency of 10Hz, pulse duration 8 ns) and coupled thereto a MOPA (Master Oscillator Power Amplifier) system (Spectra Physics 200PRO) allowing for operating with selective wavelengths (laser line ca. 0.8 nm wide) for the input excitation (in the range 420-680 nm).

The random lasing system was completed with one neutral density filter, one Glan-Laser Polariser (Thorlabs), one λ/4 and one λ/2 optical waveplates and one spherical lens (f = 100 mm) for controlling the input beam intensity, diameter and polarization state..

The laser emission was analyzed by means of a Charged Coupled Device (CCD) Ocean Optics HR4000 Spectrometer (resolution ca. 0.15nm) and the far field spatial profile was investigated with a CCD camera (DCU223M from Thorlabs).

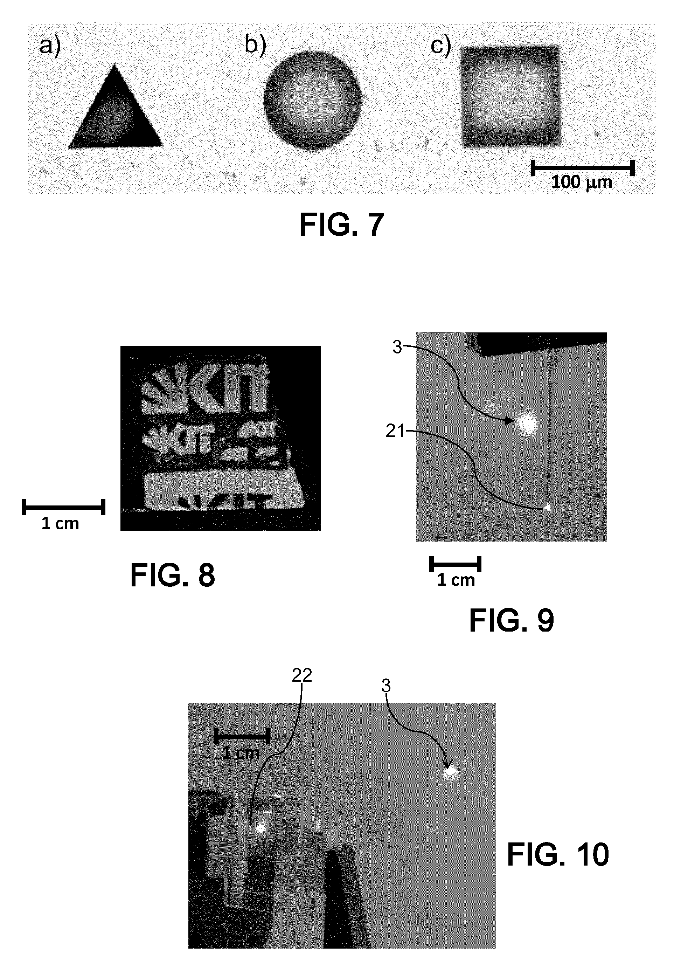

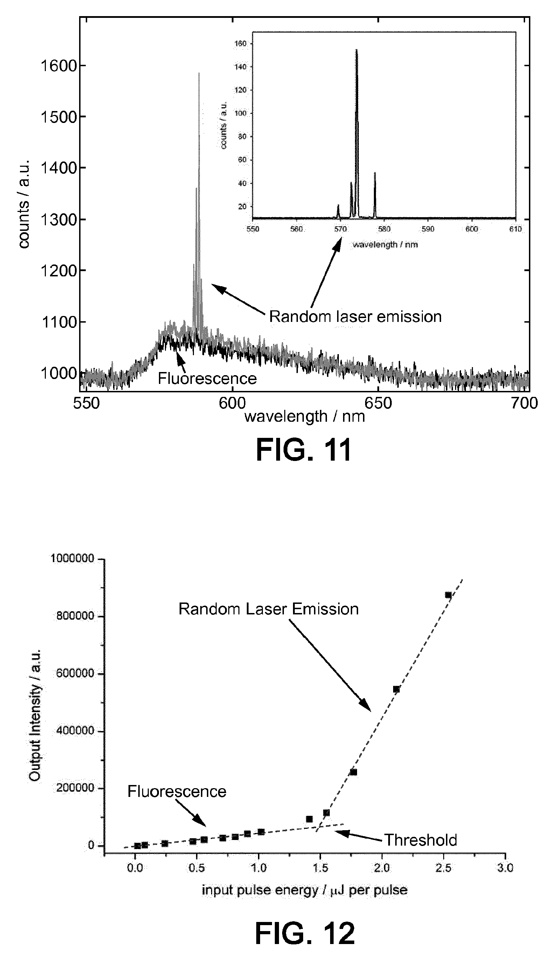

By using an excitation wavelength of 530nm, at low input pump energy densities (lower than about 1 µJ/pulse) the typical PM597 dye fluorescence spectrum is observed. Above the threshold of about 1.5 µJ/pulse, highly intense random laser emission is obtained, emerging as a collimated beam from the pumped region of the wedge cell, which hits a screen (made of white paper) with a shape of speckle-like pattern. (Figure 10 and figure 11)

Analogous observation of laser beam emerging from the liquid gain medium upon optical pumping above an energy density threshold was done with a droplet (ca. 3mm in diameter) of the same composition freely suspended in air from a syringe needle (figure 9).

Analogous observation was done on a microstructure obtained by photolithography, i.e. a block long and large 100 µm and high 40 µm, which was observed to yield random laser emission upon optical pumping above an energy density threshold of about 1 µJ/pulse.

Beside the existence of an energy threshold for the observation of laser emission, the observed emission is also confirmed to be laser emission by spectral measurements. The acquired emission spectra confirm indeed the presence of discrete sharp lasing peaks on top of the residual fluorescence (each spike having the full width half maximum, FWHM, of less than 0.5 nm). A measure for the efficiency of a laser (gain narrowing) is the narrowing factor (NF), defined as the ratio between FWHM of the emitted light below threshold and the FWHM of the emission spectrum of the random lasing system above threshold, NF= FWHM below / FWHM above. In the case of these wedge cell samples, the narrowing factor is larger than 200 for each laser spike, while NF under 200 for the free-standing droplet and NF over 250 for the photolithography-fabricated microstructure. (Figure 11)

## Claims

1. A random lasing photo-curable composition for use as random lasing gain medium comprising:
- laser dye molecules;
- an optical glue for the laser dye molecules to be solvated therein;
wherein the optical glue is mercapto ester-based and comprises methacrylate and/or derivatives thereof.

2. The random lasing photo-curable composition of claim 1, wherein the optical glue comprises at most 85 wt.% mercapto ester.

3. The random lasing photo-curable composition of claim 1 or claim 2, wherein the optical glue comprises at least 15 wt.% methacrylate or derivatives thereof.

4. The random lasing photo-curable composition of any of claim 1 to 3, wherein the methacrylate or derivatives thereof is selected from the group consisting of: tetrahydrofurfuryl methacylate.

5. A random lasing system with a gain medium made at least partly from the random lasing photo-curable composition of any claim 1 to 4.

6. The random lasing system of claim 5, wherein the random lasing photo-curable composition in the gain medium is in a liquid form.

7. The random lasing system of claim 5, wherein the random lasing photo-curable composition in the gain medium is in a solid form.

8. The random lasing system of claim 6 or claim 7, wherein the lasing photo-curable composition in the gain medium is a self-standing block or film, or suspended objects.

9. A method for manufacturing a gain medium in a solid form for a random lasing system, the method comprising:
- mixing laser dye with an optical glue to obtain a photo-curable mixture;
- coating a substrate with the photo-curable mixture;
- masking the substrate with a pattern-baring mask;
- irradiating the substrate through the mask;
- removing the mask;
- washing uncured photo-curable mixture;
wherein the optical glue is mercapto ester-based and comprises methacrylate and/or derivatives thereof.

10. A method for manufacturing a gain medium a liquid form contained in a cell for a random lasing system, the method comprising:
- mixing laser dye with an optical glue to obtain a photo-curable mixture;
- filling the cell with the photo-curable mixture;
- closing the cell;
wherein the optical glue is mercapto ester-based and comprises methacrylate and/or derivatives thereof.

11. A use of an optical glue as solvating medium for a laser dye forming a gain medium in a random lasing system, wherein the optical glue is mercapto ester-based and comprises methacrylate and/or derivatives thereof.

12. The method of claim 9 or claim 10 or the use of claim 11, wherein the optical glue comprises at most 85 wt.% mercapto ester.

13. The method of any claim 9, 10 or 12 or the use of claim 11 or claim 12, wherein the optical glue comprises at least 15 wt.% methacrylate or derivatives thereof.

14. The method of any claim 9, 10, 12 or 13 or the use of any claim 11 to 13, wherein the methacrylate or derivatives thereof is selected from the group consisting of: tetrahydrofurfuryl methacylate.
